# EUROPÄISCHE PATENTSCHRIFT

(11) **EP 2 784 809 B1**
(45) Veröffentlichungstag und Bekanntmachung des Hinweises auf die Patenterteilung: **07.06.2017**
(21) Anmeldenummer: 14154238.1
(22) Anmeldetag: 07.02.2014
(51) Int. Cl.: H01L 23/29, H01L 23/04, H01L 21/50

(54) **Leistungshalbleitermodul und Verfahren zur Herstellung eines Leistungshalbleitermoduls**
Semiconductor power module and method for manufacturing the same
Module semi-conducteur de puissance et procédé de fabrication d'un module semi-conducteur de puissance

(30) Priorität: 27.03.2013 DE 102013103116
(43) Veröffentlichungstag der Anmeldung: 01.10.2014
(73) Patentinhaber: SEMIKRON Elektronik GmbH & Co. KG, 90431 Nürnberg (DE)
(72) Erfinder: Bogen, Ingo, 90425 Nürnberg (DE); Großmann, Jörn, 90419 Nürnberg (DE); Göbl, Christian, 90441 Nürnberg (DE); Walter, Christian, 91522 Ansbach (DE); Graschl, Patrick, 91639 Wolframs-Eschenbach (DE)

(56) Entgegenhaltungen:
- EP-A2- 2 261 973
- DE-B4- 10 120 402
- US-A1- 2004 228 094

## Beschreibung

Die Erfindung betrifft ein Leistungshalbleitermodul und ein Verfahren zur Herstellung eines Leistungshalbleitermoduls.

Bei aus dem Stand der Technik bekannten Leistungshalbleitermodulen sind im Allgemeinen auf einem Substrat Leistungshalbleiterbauelemente, wie z.B. Leistungshalbleiterschalter und Dioden angeordnet und mittels einer Leiterschicht des Substrats, sowie Bonddrähten und/oder einem Folienverbund miteinander elektrisch leitend verbunden. Die Leistungshalbleiterschalter liegen dabei im Allgemeinen in Form von Transistoren, wie z.B. IGBTs (Insulated Gate Bipolar Transistor) oder MOSFETs (Metal Oxide Semiconductor Field Effect Transistor), oder in Form von Thyristoren vor.

Die auf dem Substrat angeordneten Leistungshalbleiterbauelemente sind dabei häufig elektrisch zu einer einzelnen oder mehreren sogenannten Halbbrückenschaltungen verschalten, die z.B. zum Gleich- und Wechsel richten von elektrischen Spannungen und Strömen verwendet werden.

Technikübliche Leistungshalbleitermodule weisen zur Führung von Lastströmen Gleichspannungslastanschlusselemente auf, mit Hilfe derer die Leistungshalbleiterbauelemente elektrisch leitend mit der Außenwelt verbunden sind. Die Lastströme weisen dabei in der Regel, im Gegensatz zu Hilfsströmen, welche z.B. zur Ansteuerung der Leistungshalbleiterschalter dienen, eine hohe Stromstärke auf. Die Gleichspannungslastanschlusselemente müssen in der Regel durch das Gehäuse des Leistungshalbleitermoduls geführt werden. An Leistungshalbleitermodule wird dabei oftmals die Anforderung gestellt z.B. gegen Spritzwasser (z.B. IP54) geschützt zu sein, so dass die Gleichspannungslastanschlusselemente gegen das Gehäuse abgedichtet sein müssen. Da die Gleichspannungslastanschlusselemente im Allgemeinen, zur Realisierung einer möglichst geringen Eigeninduktivität, idealerweise parallel im engen Abstand zueinander geführt werden, ist eine Abdichtung der Gleichspannungslastanschlusselemente gegen das Gehäuse schwer zu realisieren. Bei techniküblichen Leistungshalbleitermodulen werden die

Gleichspannungslastanschlusselemente in das, in der Regel aus einem Thermoplast bestehende Gehäuse, eingespritzt oder es wird nach der Montage des Leistungshalbleitermoduls das Innere des Leistungshalbleitermoduls mittels eines Vergussmittels vergossen.

Bei techniküblichen Leistungshalbleitermodulen werden somit, zur Realisierung der Abdichtung der Gleichspannungslastanschlusselemente gegen das Gehäuse, die Gleichspannungslastanschlusselemente stoffschlüssig mit dem Gehäuse verbunden.

Die techniküblichen Lösungen zur Realisierung der Abdichtung der Gleichspannungslastanschlusselemente gegen das Gehäuse weisen dabei nur eine schlechte Temperaturwechselfestigkeit auf. Weiterhin muss der Abstand zwischen den Gleichspannungslastanschlusselementen relativ groß sein, wenn die Gleichspannungslastanschlusselemente in das Gehäuse eingespritzt werden sollen, damit der Thermoplast zwischen die Gleichspannungslastanschlusselemente fließen kann und das Ausbilden von zwischen den Gleichspannungslastanschlusselementen verlaufenden Fließnähten vermieden wird.

Aus der US 2004/0228094 A1 ist ein Leistungssystem, das ein erstes und ein zweites Leistungsmodul aufweist, bekannt. Die Leistungsmodule weisen jeweils eine eine Einheit bildende Gleichspannungslastanschlussvorrichtung mit einem ersten und einem zweiten elektrisch leitenden Gleichspannungslastanschlusselement und einem dazwischen angeordneten Isolator auf.

Aus der EP 2 261 973 A2 ist ein leistungselektronisches System mit einer Umhausung, einer Kühleinrichtung, einer Stromrichterschaltung, mindestens einem Kondensator sowie mit ersten und zweiten internen und externen Verbindungseinrichtungen, bekannt.

Aus der DE 101 20 402 B4 ist ein Leistungshalbleitermodulgehäuse mit einem Korpus aus Kunststoff und mindestens einer elektrisch leitenden Anschlußfahne, die in einen Träger aus Kunststoff eingegossen ist, der mit dem Korpus wahlfrei in einer Mehrzahl von Positionen verbindbar ist, bekannt.

Es ist Aufgabe der Erfindung ein Leistungshalbleitermodul zu schaffen, bei dem die Gleichspannungslastanschlusselemente zuverlässig und mit hoher Temperaturwechselfestigkeit gegen das Gehäuse des Leistungshalbleitermoduls abgedichtet sind und der Abstand zwischen den Gleichspannungslastanschlusselementen klein ausgeführt werden kann.

Diese Aufgabe wird gelöst durch ein Leistungshalbleitermodul mit einem Substrat und auf dem Substrat angeordneten und mit dem Substrat verbundenen Leistungshalbleiterbauelementen, wobei das Leistungshalbleitermodul ein eine Ausnehmung aufweisendes erstes Gehäuseteil und eine eine bauliche Einheit bildende Gleichspannungslastanschlussvorrichtung aufweist, wobei die Gleichspannungslastanschlussvorrichtung ein erstes und ein zweites elektrisch leitendes Gleichspannungslastanschlusselement aufweist, die jeweilig mit mindestens einem Leistungshalbleiterbauelement elektrisch leitend verbunden sind, wobei das erste Gleichspannungslastanschlusselement einen außerhalb des ersten Gehäuseteils angeordneten ersten Außenanschlussabschnitt und das zweite Gleichspannungslastanschlusselement einen außerhalb des ersten Gehäuseteils angeordneten zweiten Außenanschlussabschnitt aufweist, wobei das erste Gleichspannungslastanschlusselement einen innerhalb des ersten Gehäuseteils angeordneten ersten Innenanschlussabschnitt und das zweite Gleichspannungslastanschlusselement einen innerhalb des ersten Gehäuseteils angeordneten zweiten Innenanschlussabschnitt aufweist, wobei das erste Gleichspannungslastanschlusselement einen in der Ausnehmung angeordneten ersten Durchführungsabschnitt und das zweite Gleichspannungslastanschlusselement einen in der Ausnehmung angeordneten zweiten Durchführungsabschnitt aufweist, wobei zwischen dem ersten und dem zweiten Durchführungsabschnitt ein Spalt ausgebildet ist, wobei der erste und zweite Durchführungsabschnitt mit einem elektrisch nicht leitenden Elastomer ummantelt ist und das Elastomer den Spalt ausfüllt, wobei das Elastomer stoffschlüssig mit dem ersten und dem zweiten Durchführungsabschnitt verbunden ist und mit dem ersten Gehäuseteil nicht stoffschlüssig verbunden ist, wobei das Elastomer den ersten und zweiten Durchführungsabschnitt gegen das erste Gehäuseteil abdichtet.

Weiterhin wird diese Aufgabe gelöst durch ein Verfahren zur Herstellung eines Leistungshalbleitermoduls mit einem Substrat und auf dem Substrat angeordneten und mit dem Substrat verbundenen Leistungshalbleiterbauelementen, wobei das Leistungshalbleitermodul ein eine Ausnehmung aufweisendes erstes Gehäuseteil aufweist, mit folgenden Verfahrensschritten:
- Anordnen einer eine bauliche Einheit bildenden Gleichspannungslastanschlussvorrichtung in der Ausnehmung, wobei die Gleichspannungslastanschlussvorrichtung ein erstes und ein zweites elektrisch leitendes Gleichspannungslastanschlusselement aufweist, wobei das erste Gleichspannungslastanschlusselement einen ersten Außenanschlussabschnitt und das zweite Gleichspannungslastanschlusselement einen zweiten Außenanschlussabschnitt aufweist, wobei das erste Gleichspannungslastanschlusselement einen ersten Innenanschlussabschnitt und das zweite Gleichspannungslastanschlusselement einen zweiten Innenanschlussabschnitt aufweist, wobei das erste Gleichspannungslastanschlusselement einen zwischen dem ersten Innenanschlussabschnitt und dem ersten Außenanschlussabschnitt angeordneten ersten Durchführungsabschnitt aufweist und das zweite Gleichspannungslastanschlusselement einen zwischen dem zweiten Innenanschlussabschnitt und dem zweiten Außenanschlussabschnitt angeordneten zweiten Durchführungsabschnitt aufweist, wobei zwischen dem ersten und dem zweiten Durchführungsabschnitt ein Spalt ausgebildet ist, wobei der erste und zweite Durchführungsabschnitt mit einem elektrisch nicht leitenden Elastomer ummantelt ist und das Elastomer den Spalt ausfüllt, wobei das Elastomer stoffschlüssig mit dem ersten und dem zweiten Durchführungsabschnitt verbunden ist,
   wobei die Gleichspannungslastanschlussvorrichtung derart in der Ausnehmung angeordnet wird, dass nach dem Anordnen der Gleichspannungslastanschlussvorrichtung der erste und zweite Außenanschlussabschnitt außerhalb des ersten Gehäuseteils angeordnet ist, und der erste und zweite Innenanschlussabschnitt innerhalb des ersten Gehäuseteils angeordnet ist, und der erste und zweite Durchführungsabschnitt in der Ausnehmung angeordnet ist, wobei vom Elastomer der erste und zweite Durchführungsabschnitt gegen das erste Gehäuseteil abdichtet wird,
- elektrisch leitendes Verbinden des ersten und zweiten Gleichspannungslastanschlusselements jeweils mit mindestens einem Leistungshalbleiterbauelement.

Vorteilhafte Ausbildungen der Erfindung ergeben sich aus den abhängigen Ansprüchen.

Vorteilhafte Ausbildungen des Verfahrens ergeben sich analog zu vorteilhaften Ausbildungen des Leistungshalbleitermoduls und umgekehrt.

Es erweist sich als vorteilhaft, wenn das Elastomer als Silikon ausgebildet ist, da ein Silikon eine hohe elektrische Isolationsfestigkeit aufweist.

Weiterhin erweist es sich als vorteilhaft, wenn das Elastomer eine Dichtlippe ausbildet, wobei die Dichtlippe gegen das erste Gehäuseteil drückt. Hierdurch wird eine besonders zuverlässige Abdichtung des ersten und zweiten Durchführungsabschnitts gegen das erste Gehäuseteil erzielt.

Ferner erweist es sich als vorteilhaft, wenn das Leistungshalbleitermodul ein zweites Gehäuseteil aufweist, wobei das zweite Gehäuseteil mit dem ersten Gehäuseteil verbunden ist, wobei zwischen dem ersten und dem zweiten Gehäuseteil und zwischen dem Elastomer und dem zweiten Gehäuseteil eine Dichteinrichtung angeordnet ist, die das zweite Gehäuseteil gegen das erste Gehäuseteil und das zweite Gehäuseteil gegen das Elastomer abdichtet. Hierdurch wird ein besonders einfach herstellbares Leistungshalbleitermodul geschaffen.

Weiterhin erweist es sich als vorteilhaft, wenn die Dichteinrichtung stoffschlüssig mit dem zweiten Gehäuseteil verbunden ist. Hierdurch wird ein besonders einfach herstellbares Leistungshalbleitermodul geschaffen.

Weiterhin erweist es sich als vorteilhaft, wenn der Spalt über die Länge des in der Ausnehmung angeordneten ersten und zweiten Durchführungsabschnitts hinausverläuft und das Elastomer über die gesamte Länge des Spalts den Spalt ausfüllt und das erste und zweite Gleichspannungslastanschlusselement über die gesamte Länge des Spalts vom Elastomer ummantelt ist. Hierdurch wird eine Gleichspannungslastanschlussvorrichtung geschaffen, die eine hohe elektrische Isolationsfestigkeit aufweist. Weiterhin wird somit auch ein Leistungshalbleitermodul geschaffen, das eine hohe elektrische Isolationsfestigkeit aufweist.

Ferner erweist es sich als vorteilhaft, wenn ein Verbinden eines zweiten Gehäuseteils mit dem ersten Gehäuseteil erfolgt, wobei am zweiten Gehäuseteil eine Dichteinrichtung angeordnet und stoffschlüssig mit dem zweiten Gehäuseteil verbunden ist, wobei das zweite Gehäuseteil mit dem ersten Gehäuseteil derart verbunden wird und die Dichteinrichtung derart angeordnet ist, dass nach dem Verbinden des zweiten Gehäuseteils mit dem ersten Gehäuseteil, die Dichteinrichtung zwischen dem ersten und dem zweiten Gehäuseteil und zwischen dem Elastomer und dem zweiten Gehäuseteil angeordnet ist und von der Dichteinrichtung das zweite Gehäuseteil gegen das erste Gehäuseteil und das zweite Gehäuseteil gegen das Elastomer abdichtet wird. Hierdurch wird ein besonders einfach herstellbares Leistungshalbleitermodul geschaffen.

Weiterhin erweist es sich als vorteilhaft, wenn ein Anordnen einer Dichteinrichtung an einem zweiten Gehäuseteil oder an dem ersten Gehäuseteil erfolgt und anschließend ein Verbinden des zweiten Gehäuseteils mit dem ersten Gehäuseteil erfolgt, wobei das zweite Gehäuseteil mit dem ersten Gehäuseteil derart verbunden wird und die Dichteinrichtung derart angeordnet wird, dass nach dem Verbinden des zweiten Gehäuseteils mit dem ersten Gehäuseteil, die Dichteinrichtung zwischen dem ersten und dem zweiten Gehäuseteil und zwischen dem Elastomer und dem zweiten Gehäuseteil angeordnet ist und von der Dichteinrichtung das zweite Gehäuseteil gegen das erste Gehäuseteil und das zweite Gehäuseteil gegen das Elastomer abdichtet wird. Hierdurch wird eine besonderes einfache Ausbildung der Dichteinrichtung ermöglicht.

Weiterhin erweist es sich als vorteilhaft, wenn das Elastomer in allen drei Raumrichtungen formschlüssig mit dem ersten und dem zweiten Gleichspannungslastanschlusselement verbunden ist. Wenn zusätzlich zur bestehenden stoffschlüssigen Verbindung des Elastomers mit dem ersten und zweiten Durchführungsabschnitt, das Elastomer in allen drei Raumrichtungen formschlüssig mit dem ersten und dem zweiten Gleichspannungslastanschlusselement verbunden ist, wird eine besonders feste Verbindung zwischen dem Elastomer und dem ersten und dem zweiten Gleichspannungslastanschlusselement erzielt.

Ein Ausführungsbeispiel der Erfindung ist in den Figuren dargestellt und wird im Folgenden näher erläutert. Dabei zeigen:
- FIG 1: eine perspektivische Darstellung einer Gleichspannungslastanschlussvorrichtung,
- FIG 2: eine Schnittdarstellung einer Gleichspannungslastanschlussvorrichtung,
- FIG 3: eine perspektivische Darstellung eines noch nicht fertig gestellten erfindungsgemäßen Leistungshalbleitermoduls,
- FIG 4: eine schematisierte Schnittdarstellung eines Substrat des erfindungsgemäßen Leistungshalbleitermoduls und der mit dem Substrat verbundenen Elemente des Leistungshalbleitermoduls,
- FIG 5: eine perspektivische Darstellung eines erfindungsgemäßen Leistungshalbleitermoduls,
- FIG 6: eine perspektivische Darstellung eines erfindungsgemäßen Leistungshalbleitermoduls mit einem noch nicht mit dem ersten Gehäuseteil verbundenen zweiten Gehäuseteil und
- FIG 7: eine perspektivische Darstellung eines erfindungsgemäßen Leistungshalbleitermoduls mit einem mit dem ersten Gehäuseteil verbundenen zweiten Gehäuseteil.

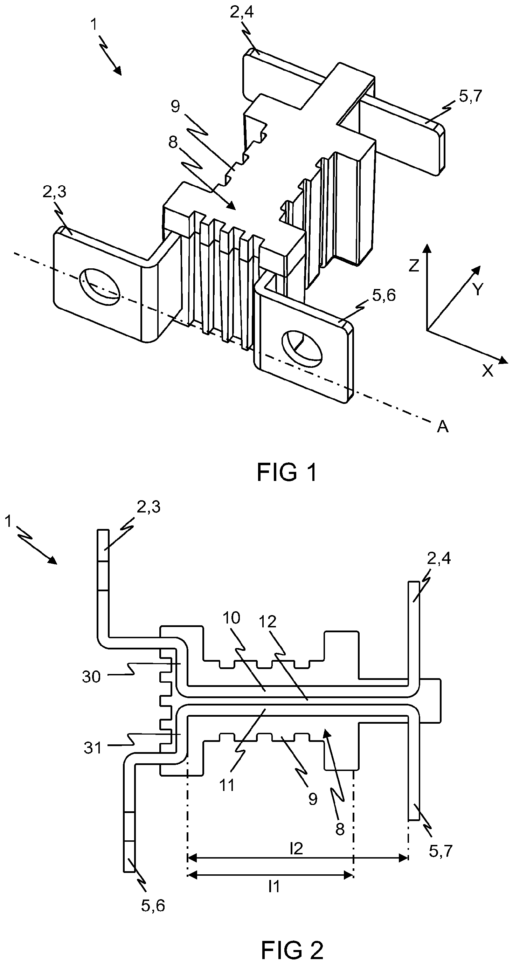

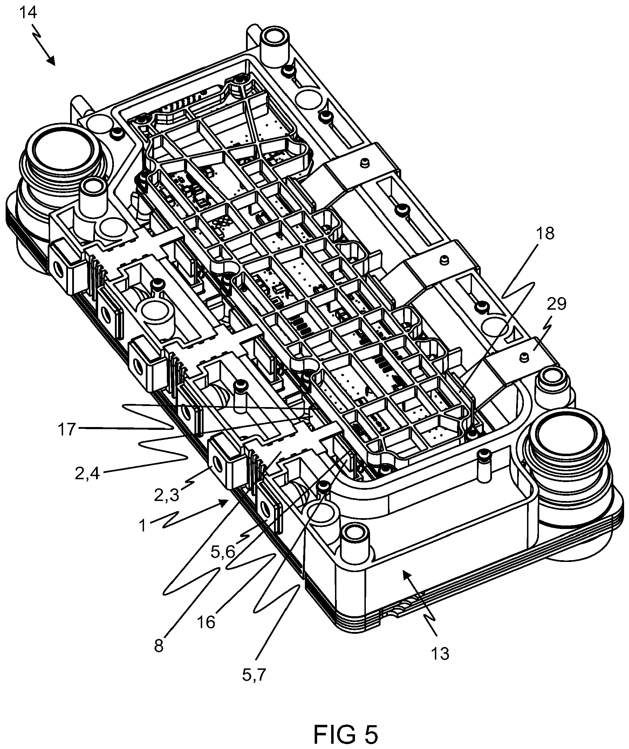

In FIG 1 ist eine perspektivische Darstellung einer Gleichspannungslastanschlussvorrichtung 1, welche erfindungsgemäß zur Durchführung von Gleichströmen durch ein erstes Gehäuseteil 13 eines erfindungsgemäßen Leistungshalbleitermoduls 14 dient (siehe FIG 5), dargestellt. In FIG 2 ist eine Schnittdarstellung der Gleichspannungslastanschlussvorrichtung 1 dargestellt, wobei der Schnitt entlang der in FIG 1 dargestellten Linie A verläuft. Die Gleichspannungslastanschlussvorrichtung 1 weist ein erstes und ein zweites elektrisch leitendes Gleichspannungslastanschlusselement 2 und 5 auf. Das erste Gleichspannungslastanschlusselement 2 weist einen ersten Außenanschlussabschnitt 3 und das zweite Gleichspannungslastanschlusselement 5 einen zweiten Außenanschlussabschnitt 6 auf. Weiterhin weist das erste Gleichspannungslastanschlusselement 2 einen ersten Innenanschlussabschnitt 4 und das zweite Gleichspannungslastanschlusselement 5 einen zweiten Innenanschlussabschnitt 7 auf. Ferner weist das erste Gleichspannungslastanschlusselement 2 einen ersten Durchführungsabschnitt 10 und das zweite Gleichspannungslastanschlusselement 5 einen zweiten Durchführungsabschnitt 11 auf. Der erste Durchführungsabschnitt 10 ist zwischen dem ersten Außenanschlussabschnitt 3 und dem ersten Innenanschlussabschnitt 4 angeordnet. Der zweite Durchführungsabschnitt 11 ist zwischen dem zweiten Außenanschlussabschnitt 6 und dem zweiten Innenanschlussabschnitt 7 angeordnet.

Zwischen dem ersten und dem zweiten Durchführungsabschnitt 10 und 11 ist ein Spalt 12 ausgebildet. Der erste und der zweite Durchführungsabschnitt 10 und 11 sind solchermaßen zueinander eng beabstandet angeordnet. Der erste und der zweite Durchführungsabschnitt 10 und 11 sind mit einem elektrisch nicht leitenden Elastomer 8 ummantelt, wobei das Elastomer 8 den Spalt 12 ausfüllt. Das Elastomer ist stoffschlüssig mit dem ersten und dem zweiten Durchführungsabschnitt 10 und 11 verbunden. Die Gleichspannungslastanschlussvorrichtung 1 liegt somit in Form einer baulichen Einheit vor und weist den ersten und zweiten Gleichspannungslastanschlusselement 2 und 5 und das Elastomer 8 auf, das das erste und das zweite Gleichspannungslastanschlusselement 2 und 5 miteinander stoffschlüssig verbindet. Das erste und das zweite Gleichspannungslastanschlusselement 2 und 5 sind vorzugsweise jeweils einstückig ausgebildet.

Vorzugsweise ist das Elastomer 8 zusätzlich in allen drei Raumrichtungen X, Y und Z formschlüssig mit dem ersten und dem zweiten Gleichspannungslastanschlusselement 2 und 5 verbunden. Im Rahmen des Ausführungsbeispiels weist hierzu das erste Gleichspannungslastanschlusselement 2 einen gegenüber dem ersten Durchführungsabschnitt 10 abgewickelten ersten Abschnitt 30 und das zweite Gleichspannungslastanschlusselement 5 einen gegenüber dem zweiten Durchführungsabschnitt 11 abgewickelten zweiten Abschnitt 31 auf, wobei die abgewinkelten ersten und zweiten Abschnitte 30 und 31 mit dem Elastomer 8 ummantelt sind. Das Elastomer 8 ist in den beiden Raumrichtungen X und Z mit dem ersten und zweiten Durchführungsabschnitt 10 und 11 formschlüssig verbunden und in den beiden Raumrichtungen Y und Z mit dem abgewinkelten ersten und zweiten Abschnitt 30 und 31 formschlüssig verbunden, so dass das Elastomer 8 in allen drei Raumrichtungen X, Y und Z formschlüssig mit dem ersten und dem zweiten Gleichspannungslastanschlusselement 2 und 5 verbunden ist.

Das Elastomer 8 ist vorzugsweise als Silikon ausgebildet. Das Silikon liegt vorzugsweise in Form eines vernetzten Liquid Silicone Rubbers oder in Form eines vernetzten Solid Silicone Rubbers vor. Beim Ausführungsbeispiel liegt das Elastomer 8 in Form eines vernetzten Liquid Silicone Rubbers vor. Zur Herstellung der Gleichspannungslastanschlussvorrichtung 1 wird das erste und zweite Gleichspannungslastanschlusselement 2 und 5 vorzugweise in einem zweiteiligen Werkzeug angeordnet. Anschließend wird eine flüssige Vorform des Elastomers 8, die z.B. in Form eines Liquid Silicone Rubbers vorliegen kann, in das Werkzeug eingespritzt. Anschließend erfolgt eine Temperaturbeaufschlagung, wodurch sich der Liquid Silicone Rubber vernetzt und zu dem Elastomer 8 verfestigt. Ein Liquid Silicone Rubber kann im Gegensatz zu einem Termoplast sehr gut in den Spalt 12 eindringen und diesen vollständig und homogen ohne das Fließnähte entstehen ausfüllen, so dass das erste und zweite Gleichspannungslastanschlusselement 2 und 5 zuverlässig und temperaturwechselfest voneinander elektrisch isoliert sind.

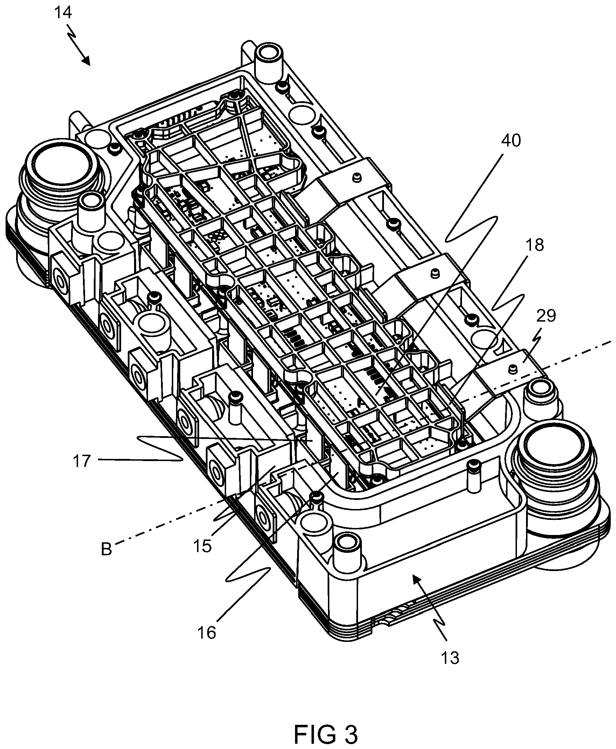

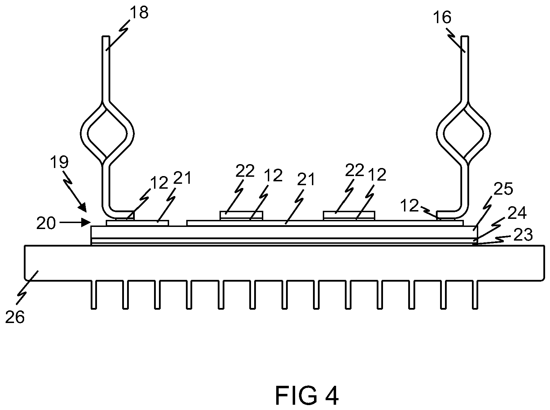

In FIG 3 ist eine perspektivische Darstellung eines noch nicht fertig gestellten erfindungsgemäßen Leistungshalbleitermoduls 14 dargestellt. In FIG 4 ist eine schematisierte Schnittdarstellung eines Substrats 19 des erfindungsgemäßen Leistungshalbleitermoduls 14 und der mit dem Substrat 19 verbundenen Elemente des Leistungshalbleitermoduls 14 dargestellt, wobei der Schnitt entlang der in FIG 3 dargestellten Linie B verläuft. Das Leistungshalbleitermodul 14 weist ein erstes Gehäuseteil 13 auf, das beim Ausführungsbeispiel, die Leistungshalbleiterbauelemente 22 des Leistungshalbleitermoduls 14 in lateraler Richtung umschließt. Das erste Gehäuseteil 13 weist im Rahmen des Ausführungsbeispiels drei zur Durchführung von Gleichströmen dienende Ausnehmungen auf, wobei der Übersichtlichkeit halber in den Figuren nur eine Ausnehmung 15 mit einem Bezugszeichen versehen ist. Es sei an dieser Stelle angemerkt, das im Rahmen des Ausführungsbeispiels ein 3-phasiges Leistungshalbleitermodul 14 dargestellt ist, bei dem eine Gleichspannung in eine 3-phasige Wechselspannung wechselgerichtet bzw. eine 3-phasige Wechselspannung in eine Gleichspannung gleichgerichtet wird. Die folgende Beschreibung beschreibt dabei beispielhaft den Aufbau des Leitungshalbleitermoduls 14, hinsichtlich eines Substrats und der dem Substrat zugeordneten Elemente, bezüglich der Erzeugung einer 1-phasigen Wechselspannung. Das Substrat 19 bzw. die betreffende Anordnung zur Erzeugung der 1-phasigen Wechselspannung ist dabei im Rahmen des Ausführungsbeispiels in identischer Ausführung dreifach vorhanden, so dass, wie schon oben beschrieben, vom Leitungshalbleitermodul 14 aus einer Gleichspannung eine 3-phasige Wechselspannung erzeugt wird bzw. eine 3-phasige Wechselspannung in eine Gleichspannung gleichgerichtet wird. Das erstes Gehäuseteil 13 besteht vorzugsweise aus einem Thermoplast und liegt vorzugsweise in Form eines Spritzgussteils vor.

Das Leistungshalbleitermodul 1 weist ein Substrat 19, das beim Ausführungsbeispiel in Form eines DCB-Substrats vorliegt und auf dem Substrat 19 angeordnete und mit dem Substrat 19 verbundene Leistungshalbleiterbauelemente 22 auf. Das jeweilige Leistungshalbleiterbauelement liegt vorzugsweise in Form eines Leistungshalbleiterschalters oder einer Diode vor. Die Leistungshalbleiterschalter liegen dabei im Allgemeinen in Form von Transistoren, wie z.B. IGBTs (Insulated Gate Bipolar Transistor) oder MOSFETs (Metal Oxide Semiconductor Field Effect Transistor), oder in Form von Thyristoren vor. Im Rahmen des Ausführungsbeispiels weisen die Leistungshalbleiterbauelemente 22 an Ihrer dem Substrat 19 zugewandten Seite jeweilig einen ersten Leistungshalbleiterlaststromanschluss (z.B. Emitter) und an Ihrer dem Substrat 19 abgewandten Seite jeweilig einen zweiten Leistungshalbleiterlaststromanschluss (z.B. Kollektor) auf.

Das Substrat 19 weist einen Isolierstoffkörper 25 und eine auf einer ersten Seite des Isolierstoffkörpers 25 angeordnete und mit dem Isolierstoffkörper 25 verbundene elektrisch leitende strukturierte erste Leitungsschicht 20 auf, die im Rahmen des Ausführungsbeispiels Leiterbahnen 21 ausbildet. Vorzugsweise weist das Substrat 19 eine elektrisch leitende, vorzugsweise unstrukturierte zweite Leitungsschicht 24 auf, wobei der Isolierstoffkörper 25 zwischen der strukturierten ersten Leitungsschicht 20 und der zweiten Leitungsschicht 24 angeordnet ist. Die strukturierte erste Leitungsschicht 20 des Substrats 19 kann z.B. aus Kupfer bestehen. Das Substrat 19 kann, wie beim Ausführungsbeispiel, in Form eines Direct Copper Bonded Substrats (DCB-Substrat) oder in Form eines Insulated Metal Substrats (IMS) vorliegen. Im Falle eines DCB-Substrats kann der Isolierstoffkörper 25 z.B. aus einer Keramik bestehen und die zweite Leitungsschicht 24 des Substrats 19 z.B. aus Kupfer bestehen. Im Falle eines Insulated Metal Substrats kann der Isolierstoffkörper 25 z.B. aus einer Schicht aus Polyimid oder Epoxy bestehen und die zweite Leitungsschicht 24 des Substrats 19 aus einem Metallformkörper bestehen. Der Metallformkörper kann z.B. aus Aluminium oder einer Aluminiumlegierung bestehen.

Weiterhin weist das Leistungshalbleitermodul 1 elektrisch leitende Gleichspannungsverbindungselemente 16 und 17 auf, die beim fertigen Leistungshalbleitermodul 14 das Substrat 19, genauer ausgedrückt die erste Leitungsschicht 20 des Substrats 19 mit einem jeweilig zugeordneten elektrisch leitenden Gleichspannungslastanschlusselement der Gleichspannungslastanschlussvorrichtung 1 verbinden. Weiterhin weist das Leistungshalbleitermodul 14 ein Wechselspannungsverbindungselement 18 auf, das beim fertigen Leistungshalbleitermodul 14 das Substrat 19, genauer ausgedrückt die erste Leitungsschicht 20 des Substrat 19 mit einem zugeordneten elektrisch leitenden Wechselspannungslastanschlusselement 29 verbindet. Die Lastströme, welche durch die Gleichspannungslastanschlussvorrichtung 1 und durch das Wechselspannungslastanschlusselement 29 fließen, weisen dabei in der Regel, im Gegensatz zu Hilfsströmen, welche z.B. zur Ansteuerung der Leistungshalbleiterbauelemente dienen, wenn die Leistungshalbleiterbauelemente als Leistungshalbleiterschalter ausgebildet sind, eine hohe Stromstärke auf.

Vorzugsweise ist die Verbindung zwischen den Leistungshalbleiterbauelementen 22 und dem Substrat 19, und/oder zwischen den Gleichspannungsverbindungselementen 16 und 17 und dem Substrat 19, und/oder zwischen dem zwischen dem Wechselspannungsverbindungselement 18 und dem Substrat 19, jeweilig als stoffschlüssige oder kraftschlüssige Verbindung realisiert. Die jeweilige stoffschlüssige Verbindung kann z.B. in Form einer Schweiß-, Löt-, Klebe- oder Sinterverbindung vorliegen, wobei im Falle der Verbindung zwischen den Leistungshalbleiterbauelementen 22 und dem Substrat 19, diese vorzugsweise in Form einer Löt-, Klebe- oder Sinterverbindung vorliegt. Im Falle einer Klebeverbindung wird eine elektrisch leitfähiger Klebstoff verwendet.

Im Rahmen des Ausführungsbeispiels sind die im vorstehenden Absatz genannten Verbindungen als Sinterverbindungen realisiert, so dass beim Ausführungsbeispiel zwischen den Leistungshalbleiterbauelementen 22 und dem Substrat 19, und zwischen den Gleichspannungsverbindungselementen 16 und 17 und dem Substrat 19, und zwischen dem zwischen dem Wechselspannungsverbindungselement 18 und dem Substrat 19, jeweilig eine Sinterschicht 12 angeordnet ist.

Das Substrat 19 ist vorzugsweise an seiner den Leistungshalbleiterbauelementen 22 abgewandten Seite mit einem Metallformkörper 26 verbunden. Der Metallformkörper 26 kann z.B. als Metallplatte, welche zum thermischen Anbinden des Substrats 19 an einen Kühlkörper dient, oder wie im Ausführungsbeispiel als Kühlkörper ausgebildet sein. Der Kühlkörper weist vorzugsweise Kühlfinnen oder Kühlnoppen auf. Die Verbindung zwischen dem Substrat 19 und Metallformkörper 26 kann als stoffschlüssige oder kraftschlüssige Verbindung realisiert sein. Die stoffschlüssige Verbindung kann z.B. in Form einer Schweiß-, Löt-, Klebe- oder Sinterverbindung vorliegen, wobei die Verwendung einer Sinterverbindung besonders vorteilhaft ist, da diese eine hohe mechanische Festigkeit und eine hohe thermische Leitfähigkeit aufweist. Beim Ausführungsbeispiel ist die Verbindung zwischen dem Substrat 19 und dem Metallformkörper 26 als Sinterverbindung realisiert, so dass zwischen dem Substrat 19 und dem Metallformkörper 26 eine Sinterschicht 23 angeordnet ist.

Es sei an dieser Stelle angemerkt, dass im Sinne der Erfindung unter einem Kühlkörper ein fester Körper verstanden wird, der im Betrieb des Leistungshalbleitermoduls dazu dient von einem anderen festen Körper Wärme aufzunehmen und die aufgenommene Wärme oder einen überwiegenden Teil der aufgenommenen Wärme an ein flüssiges Medium und/oder an ein gasförmiges Medium, das einen Kontakt mit dem Kühlkörper aufweist, abzugeben. Gegebenenfalls kann ein kleiner Teil der vom Kühlkörper aufgenommenen Wärme an einen weiteren festen Körper abgegeben werden.

Es sei weiterhin angemerkt, dass die Leistungshalbleiterbauelemente 22 an Ihrer dem Substrat 19 abgewandten Seite, mittels z.B. Bonddrähten und/oder einem Folienverbund miteinander und mit den Leiterbahnen 21 des Substrats 19, entsprechend der gewünschten elektrischen Schaltung, welche das Leistungshalbleitermodul 14 realisieren soll, elektrisch leitend miteinander verbunden sind. Der Übersichtlichkeit halber sind diese elektrischen Verbindungen in FIG 4 nicht dargestellt.

Wie in FIG 3 dargestellt, weist das Leistungshalbleitermoduls 14 vorzugsweise eine Leiterplatte 40 auf, auf der die zur Ansteuerung der Leistungshalbleiterschalter des Leistungshalbleitermoduls 14 benötigten elektrischen Treiberschaltungen realisiert sind.

Im Folgenden wird ein erfindungsgemäßes Verfahren zur Herstellung des erfindungsgemäßen Leistungshalbleitermoduls 14 beschrieben.

In einem ersten Verfahrensschritt erfolgt ein Anordnen der eine bauliche Einheit bildenden Gleichspannungslastanschlussvorrichtung 1 in der Ausnehmung 15 des ersten Gehäuseteils 13, wobei die Gleichspannungslastanschlussvorrichtung 1 derart in der Ausnehmung 15 angeordnet wird, dass nach dem Anordnen der Gleichspannungslastanschlussvorrichtung 1 der erste und zweite Außenanschlussabschnitt 3 und 6 der Gleichspannungslastanschlussvorrichtung 1 außerhalb des ersten Gehäuseteils 13 angeordnet ist, und der erste und zweite Innenanschlussabschnitt 4 und 7 der Gleichspannungslastanschlussvorrichtung 1 innerhalb des ersten Gehäuseteils 13 angeordnet ist, und der erste und zweite Durchführungsabschnitt 10 und 11 in der Ausnehmung 15 angeordnet ist, wobei vom Elastomer 8 der Gleichspannungslastanschlussvorrichtung 1, der erste und zweite Durchführungsabschnitt 10 und 11 gegen das erste Gehäuseteil 13 abdichtet wird. Das Elastomer 8 ist somit mit dem ersten Gehäuseteil 13 nicht stoffschlüssig verbunden. Das Elastomer 8 ist mit dem ersten Gehäuseteil 13 formschlüssig, insbesondere vorzugsweise ausschließlich formschlüssig, verbunden. Das Elastomer 8 ist mit dem ersten Gehäuseteil 13 lösbar verbunden. Im Rahmen des Ausführungsbeispiels erfolgt das Anordnen der eine bauliche Einheit bildenden Gleichspannungslastanschlussvorrichtung 1 in der Ausnehmung 15 in Form eines Einlegens der Gleichspannungslastanschlussvorrichtung 1 in die Ausnehmung 15.

In FIG 5 ist eine perspektivische Darstellung des erfindungsgemäßen Leistungshalbleitermoduls 14 bei dem die Gleichspannungslastanschlussvorrichtung 1 in die die Ausnehmung 15 des ersten Gehäuseteils 13 eingelegt ist, dargestellt.

Vorzugsweise verläuft der Spalt 12 über die Länge l1 des in der Ausnehmung 15 angeordneten ersten und zweiten Durchführungsabschnitts 10 und11 hinaus und das Elastomer 8 füllt über die gesamte Länge l2 des Spalts 12 den zwischen dem ersten und zweiten Gleichspannungslastanschlusselement 2 und 5 ausgebildeten Spalt 12 aus und das erste und zweite Gleichspannungslastanschlusselement 2 und 5 ist über die gesamte Länge l2 des Spalts 12 vom Elastomer 8 ummantelt (siehe FIG 2). Hierdurch wird zwischen dem ersten und zweiten Gleichspannungslastanschlusselement 2 und 5 eine hohe elektrische Isolationsfestigkeit erzielt.

Es sei an dieser Stelle angemerkt, dass die Ausnehmung 15 des ersten Gehäuseteils 13 auch in Form eines durch das erste Gehäuseteil 13 hindurchgehenden Durchgangslochs ausgebildet sein kann und das Anordnen der baulichen Einheit bildenden Gleichspannungslastanschlussvorrichtung 1 in die Ausnehmung 15 des ersten Gehäuseteils 13 in Form eines Hineinsteckens der Gleichspannungslastanschlussvorrichtung 1 in das Durchgangslochs vorliegen kann, wobei in diesem Fall, der erste und zweite Innenanschlussabschnitt 4 und 7 der Gleichspannungslastanschlussvorrichtung 1 nicht, wie beim Ausführungsbeispiel, vorzugsweise einen gegenüber dem ersten und zweiten Durchführungsabschnitt 10 und 11 abgewinkelten Bereich aufweist, sondern zumindest im Wesentlichen mit der Verlaufsrichtung des ersten und dem zweiten Durchführungsabschnitts 10 und 11 übereinstimmt.

Vorzugsweise bildet das Elastomer 8 eine Dichtlippe 9 aus (siehe FIG 2), wobei die Dichtlippe 9 gegen das erste Gehäuseteil 13 drückt. Vorzugsweise bildet das Elastomer 18, wie beim Ausführungsbeispiel, mehrere hintereinander angeordnete Dichtlippen aus, die gegen das erste Gehäuseteil 13 drücken.

Es sei weiterhin angemerkt, dass das Gehäuse des Leistungshalbleitermoduls 14 auch nur aus einem ersten Gehäuseteil bestehen kann.

In einem weiteren Verfahrensschritt erfolgt ein elektrisch leitendes Verbinden des ersten und zweiten Gleichspannungslastanschlusselements 2 und 5 jeweils mit mindestens einem Leistungshalbleiterbauelement 22 des Leistungshalbleitermoduls14. Im Rahmen des Ausführungsbeispiels wird hierzu der erste Innenanschlussabschnitt 4 des ersten Gleichspannungslastanschlusselements 2 mit dem Gleichspannungsverbindungselement 17 und der zweite Innenanschlussabschnitt 7 des zweiten Gleichspannungslastanschlusselements 5 mit dem Gleichspannungsverbindungselement 16 verbunden, wobei die jeweilige Verbindung z.B. in Form einer Schweiß-, Löt-, Klebe- oder Sinterverbindung vorliegen kann. In analoger Weise wird vorzugsweise das Wechselspannungslastanschlusselement 29 mit dem Wechselspannungsverbindungselement 18 verbunden.

Es sei angemerkt, dass im Sinne der vorliegenden Erfindung unter dem Ausdruck, dass zwei Elemente elektrisch leitend verbunden sind bzw. miteinander elektrisch leitend verbunden werden, sowohl eine direkte elektrisch leitende Verbindung von zwei Elementen, mittels z.B. einer Schweiß-, Löt- oder Sinterverbindung, die zwischen den beiden Elementen besteht, als auch eine indirekte elektrisch leitende Verbindung, mittels z.B. einem oder mehreren Leitungselementen, wie z.B. einer Leiterbahn, einem Bonddraht, einem elektrisch leitenden Folienverbund, einer Stromschiene, einem Gleichspannungsverbindungselement, einem Wechselspannungsverbindungselement oder einem Kabel, die die beiden Elemente elektrisch miteinander verbinden, so dass eine bidirektionaler elektrischer Stromfluss zwischen den beiden elektrisch miteinander leitend verbunden Elementen möglich ist, verstanden wird.

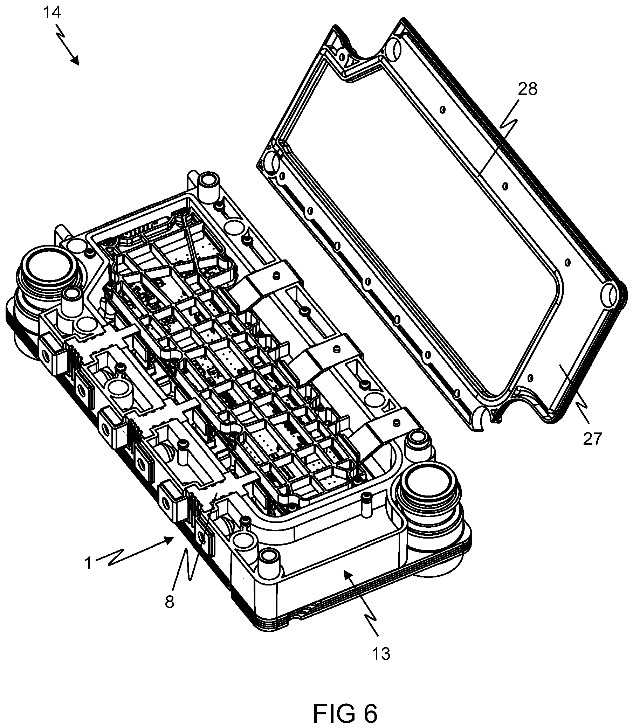

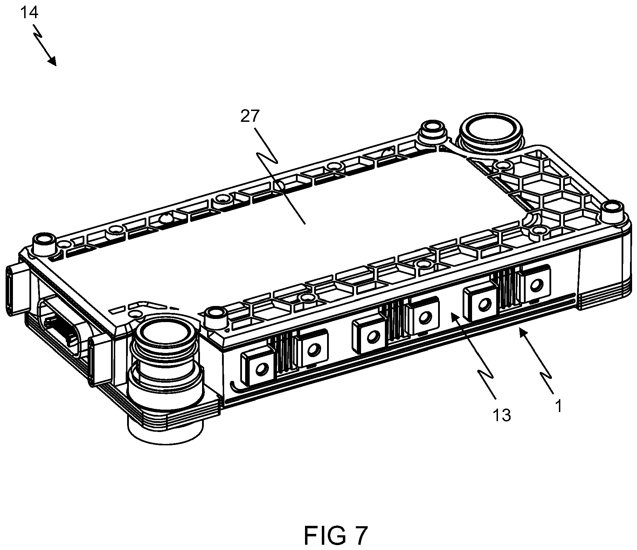

Vorzugsweise erfolgt in einem weiteren Verfahrensschritt ein Verbinden eines zweiten Gehäuseteils 27 mit dem ersten Gehäuseteil 13, wobei am zweiten Gehäuseteil 27 eine Dichteinrichtung 28 angeordnet und stoffschlüssig mit dem zweiten Gehäuseteil 27 verbunden ist, wobei das zweite Gehäuseteil 27 mit dem ersten Gehäuseteil 13 derart verbunden wird und die Dichteinrichtung derart angeordnet ist, dass nach dem Verbinden des zweiten Gehäuseteils 27 mit dem ersten Gehäuseteil 13, die Dichteinrichtung 28 zwischen dem ersten und dem zweiten Gehäuseteil 13 und 27, und zwischen dem Elastomer 8 der Gleichspannungslastanschlussvorrichtung 1 und dem zweiten Gehäuseteil 27 angeordnet ist und von der Dichteinrichtung 28 das zweite Gehäuseteil 27 gegen das erste Gehäuseteil 13 und das zweite Gehäuseteil 27 gegen das Elastomer 8 abdichtet wird. Das zweite Gehäuseteil 27 ist im Rahmen des Ausführungsbeispiels als ein Gehäusedeckel ausgebildet. In FIG 6 ist eine perspektivische Darstellung des erfindungsgemäßen Leistungshalbleitermoduls 14 mit einem noch nicht mit dem ersten Gehäuseteil 13 verbundenen zweiten Gehäuseteil 27 dargestellt und in FIG 7 ist eine perspektivische Darstellung des erfindungsgemäßen Leistungshalbleitermoduls 14 mit einem mit dem ersten Gehäuseteil 13 verbundenen zweiten Gehäuseteil 27 dargestellt. Die Dichteinrichtung 28 ist auf der dem ersten Gehäuseteil 13 zugewandten Seite des zweiten Gehäuseteils 27 angeordnet. Die Dichteinrichtung 28 besteht im Rahmen des Ausführungsbeispiels aus einem geschlossen umlaufend angeordneten elastischen Material, wie z.B. Silikon oder Gummi.

Es sei dabei angemerkt, dass die Dichteinrichtung 28 nicht notwendigerweise mit dem zweiten Gehäuseteil 27 stoffschlüssig verbunden sein muss, sondern auch als ein separates Element, das z.B. in Form eines Dichtrings ausgebildet sein kann und aus einem elastischen Material, wie z.B. Silikon oder Gummi, bestehen kann, ausgebildet sein kann. In diesem Fall erfolgt ein Anordnen der Dichteinrichtung 28 an dem zweiten Gehäuseteil 27 oder an dem ersten Gehäuseteil 13 und anschließend ein Verbinden des zweiten Gehäuseteils 27 mit dem ersten Gehäuseteil 13, wobei das zweite Gehäuseteil 27 mit dem ersten Gehäuseteil 13 derart verbunden wird und die Dichteinrichtung 28 derart angeordnet wird, dass nach dem Verbinden des zweiten Gehäuseteils 27 mit dem ersten Gehäuseteil 13, die Dichteinrichtung 28 zwischen dem ersten und dem zweiten Gehäuseteil 13 und 27, und zwischen dem Elastomer 8 und dem zweiten Gehäuseteil 27 angeordnet ist und von der Dichteinrichtung 28 das zweite Gehäuseteil 27 gegen das erste Gehäuseteil 13 und das zweite Gehäuseteil 27 gegen das Elastomer8 abdichtet wird.

Im Rahmen des Ausführungsbeispiels wird das zweite Gehäuseteils 27 mit dem ersten Gehäuseteil 13 mittels einer Schraubverbindung miteinander verbunden. Alternativ könnte das zweite Gehäuseteils 27 mit dem ersten Gehäuseteil 13 auch z.B. mittels einer Schnapp-Rastverbindung oder einer anderen Verbindungsart miteinander verbunden sein.

Im Rahmen des Ausführungsbeispiels weist beim Betrieb des erfindungsgemäßen Leistungshalbleitermoduls 14 das erste Gleichspannungslastanschlusselement 2 ein positives elektrisches Spannungspotential und das zweite Gleichspannungslastanschlusselement 5 ein negatives elektrisches Spannungspotential auf.

Im Rahmen des Ausführungsbeispiels weist das Gehäuse des Leistungshalbleitermoduls 14 ein erstes und ein zweites Gehäuseteil 13 und 27 auf.

## Patentansprüche

1. Leistungshalbleitermodul mit einem Substrat (19) und auf dem Substrat (19) angeordneten und mit dem Substrat (19) verbundenen Leistungshalbleiterbauelementen (22), wobei das Leistungshalbleitermodul (14) ein eine Ausnehmung (15) aufweisendes erstes Gehäuseteil (13) und eine ein bauliche Einheit bildende Gleichspannungslastanschlussvorrichtung (1) aufweist, wobei die Gleichspannungslastanschlussvorrichtung (1) ein erstes und ein zweites elektrisch leitendes Gleichspannungslastanschlusselement (2,5) aufweist, die jeweilig mit mindestens einem Leistungshalbleiterbauelement (22) elektrisch leitend verbunden sind, wobei das erste Gleichspannungslastanschlusselement (2) einen außerhalb des ersten Gehäuseteils (13) angeordneten ersten Außenanschlussabschnitt (3) und das zweite Gleichspannungslastanschlusselement (5) einen außerhalb des ersten Gehäuseteils (13) angeordneten zweiten Außenanschlussabschnitt (6) aufweist, wobei das erste Gleichspannungslastanschlusselement (2) einen innerhalb des ersten Gehäuseteils (13) angeordneten ersten Innenanschlussabschnitt (4) und das zweite Gleichspannungslastanschlusselement (5) einen innerhalb des ersten Gehäuseteils (13) angeordneten zweiten Innenanschlussabschnitt (7) aufweist, wobei das erste Gleichspannungslastanschlusselement (2) einen in der Ausnehmung (15) angeordneten ersten Durchführungsabschnitt (10) und das zweite Gleichspannungslastanschlusselement (5) einen in der Ausnehmung (15) angeordneten zweiten Durchführungsabschnitt (11) aufweist, wobei zwischen dem ersten und dem zweiten Durchführungsabschnitt (10,11) ein Spalt (12) ausgebildet ist, wobei der erste und zweite Durchführungsabschnitt (10,11) mit einem elektrisch nicht leitenden Elastomer (8) ummantelt ist und das Elastomer (8) den Spalt (12) ausfüllt, wobei das Elastomer (8) stoffschlüssig mit dem ersten und dem zweiten Durchführungsabschnitt (10,11) verbunden ist und mit dem ersten Gehäuseteil (13) nicht stoffschlüssig verbunden ist, wobei das Elastomer (8) den ersten und zweiten Durchführungsabschnitt (10,11) gegen das erste Gehäuseteil (13) abdichtet.

2. Leistungshalbleitermodul nach Anspruch 1, **dadurch gekennzeichnet, dass** das Elastomer (8) als Silikon ausgebildet ist.

3. Leistungshalbleitermodul nach einem der vorhergehenden Ansprüche, **dadurch gekennzeichnet, dass** das Elastomer (8) eine Dichtlippe (9) ausbildet, wobei die Dichtlippe (9) gegen das erste Gehäuseteil (13) drückt.

4. Leistungshalbleitermodul nach einem der vorhergehenden Ansprüche, **dadurch gekennzeichnet, dass** das Leistungshalbleitermodul (14) ein zweites Gehäuseteil (27) aufweist, wobei das zweite Gehäuseteil (27) mit dem ersten Gehäuseteil (13) verbunden ist, wobei zwischen dem ersten und dem zweiten Gehäuseteil (13,27) und zwischen dem Elastomer (8) und dem zweiten Gehäuseteil (27) eine Dichteinrichtung (28) angeordnet ist, die das zweite Gehäuseteil (27) gegen das erste Gehäuseteil (13) und das zweite Gehäuseteil (27) gegen das Elastomer (8) abdichtet.

5. Leistungshalbleitermodul nach Anspruch 4, **dadurch gekennzeichnet, dass** die Dichteinrichtung (28) stoffschlüssig mit dem zweiten Gehäuseteil (27) verbunden ist.

6. Leistungshalbleitermodul nach einem der vorhergehenden Ansprüche, **dadurch gekennzeichnet, dass** der Spalt (12) über die Länge (l1) des in der Ausnehmung (15) angeordneten ersten und zweiten Durchführungsabschnitts (10,11) hinausverläuft und das Elastomer (8) über die gesamte Länge (12) des Spalts (12) den Spalt (12) ausfüllt und das erste und zweite Gleichspannungslastanschlusselement (2,5) über die gesamte Länge (12) des Spalts (12) vom Elastomer (8) ummantelt ist.

7. Leistungshalbleitermodul nach einem der vorhergehenden Ansprüche, **dadurch gekennzeichnet, dass** das Elastomer (8) in allen drei Raumrichtungen (X,Y,Z) formschlüssig mit dem ersten und dem zweiten Gleichspannungslastanschlusselement (2,5) verbunden ist, wobei hierzu das erste Gleichspannungslastanschlusselement (2) einen gegenüber dem ersten Durchführungsabschnitt (10) abgewickelten ersten Abschnitt (30) und das zweite Gleichspannungslastanschlusselement (5) einen gegenüber dem zweiten Durchführungsabschnitt (11) abgewickelten zweiten Abschnitt (31) aufweist, wobei die abgewinkelten ersten und zweiten Abschnitte (30,31) mit dem Elastomer (8) ummantelt sind.

8. Verfahren zur Herstellung eines Leistungshalbleitermoduls mit einem Substrat (19) und auf dem Substrat (19) angeordneten und mit dem Substrat (19) verbundenen Leistungshalbleiterbauelementen (22), wobei das Leistungshalbleitermodul (14) ein eine Ausnehmung (15) aufweisendes erstes Gehäuseteil (13) aufweist, mit folgenden Verfahrensschritten:
• Anordnen einer eine bauliche Einheit bildenden Gleichspannungslastanschlussvorrichtung (1) in der Ausnehmung (15), wobei die Gleichspannungslastanschlussvorrichtung (1) ein erstes und ein zweites elektrisch leitendes Gleichspannungslastanschlusselement (2,5) aufweist, wobei das erste Gleichspannungslastanschlusselement (2) einen ersten Außenanschlussabschnitt (3) und das zweite Gleichspannungslastanschlusselement (5) einen zweiten Außenanschlussabschnitt (6) aufweist, wobei das erste Gleichspannungslastanschlusselement (2) einen ersten Innenanschlussabschnitt (4) und das zweite Gleichspannungslastanschlusselement (5) einen zweiten Innenanschlussabschnitt (7) aufweist, wobei das erste Gleichspannungslastanschlusselement (2) einen zwischen dem ersten Innenanschlussabschnitt (4) und dem ersten Außenanschlussabschnitt (3) angeordneten ersten Durchführungsabschnitt (10) aufweist und das zweite Gleichspannungslastanschlusselement (5) einen zwischen dem zweiten Innenanschlussabschnitt (7) und dem zweiten Außenanschlussabschnitt (6) angeordneten zweiten Durchführungsabschnitt (11) aufweist, wobei zwischen dem ersten und dem zweiten Durchführungsabschnitt (10,11) ein Spalt (12) ausgebildet ist, wobei der erste und zweite Durchführungsabschnitt (10,11) mit einem elektrisch nicht leitenden Elastomer (8) ummantelt ist und das Elastomer (8) den Spalt (12) ausfüllt, wobei das Elastomer (8) stoffschlüssig mit dem ersten und dem zweiten Durchführungsabschnitt (10,11) verbunden ist,
wobei die Gleichspannungslastanschlussvorrichtung (1) derart in der Ausnehmung (15) angeordnet wird, dass nach dem Anordnen der Gleichspannungslastanschlussvorrichtung (1) der erste und zweite Außenanschlussabschnitt (3,6) außerhalb des ersten Gehäuseteils (13) angeordnet ist, und der erste und zweite Innenanschlussabschnitt (4,7) innerhalb des ersten Gehäuseteils (13) angeordnet ist, und der erste und zweite Durchführungsabschnitt (10,11) in der Ausnehmung (15) angeordnet ist, wobei vom Elastomer (8) der erste und zweite Durchführungsabschnitt (10,11) gegen das erste Gehäuseteil (13) abdichtet wird,
• elektrisch leitendes Verbinden des ersten und zweiten Gleichspannungslastanschlusselements (2,5) jeweils mit mindestens einem Leistungshalbleiterbauelement (22).

9. Verfahren nach Anspruch 8 mit folgendem weiteren Verfahrensschritt:
• Verbinden eines zweiten Gehäuseteils (27) mit dem ersten Gehäuseteil (13), wobei am zweiten Gehäuseteil (27) eine Dichteinrichtung (28) angeordnet und stoffschlüssig mit dem zweiten Gehäuseteil (27) verbunden ist, wobei das zweite Gehäuseteil (27) mit dem ersten Gehäuseteil (13) derart verbunden wird und die Dichteinrichtung (28) derart angeordnet wird, dass nach dem Verbinden des zweiten Gehäuseteils (27) mit dem ersten Gehäuseteil (13), die Dichteinrichtung (28) zwischen dem ersten und dem zweiten Gehäuseteil (13,27) und zwischen dem Elastomer (8) und dem zweiten Gehäuseteil (27) angeordnet ist und von der Dichteinrichtung (28) das zweite Gehäuseteil (27) gegen das erste Gehäuseteil (13) und das zweite Gehäuseteil (27) gegen das Elastomer (8) abdichtet wird.

10. Verfahren nach Anspruch 8 mit folgendem weiteren Verfahrensschritten:
• Anordnen einer Dichteinrichtung (28) an einem zweiten Gehäuseteil (27) oder an dem ersten Gehäuseteil (13),
• Verbinden des zweiten Gehäuseteils (27) mit dem ersten Gehäuseteil (13), wobei das zweite Gehäuseteil (27) mit dem ersten Gehäuseteil (13) derart verbunden wird und die Dichteinrichtung (28) derart angeordnet wird, dass nach dem Verbinden des zweiten Gehäuseteils (27) mit dem ersten Gehäuseteil (13), die Dichteinrichtung (28) zwischen dem ersten und dem zweiten Gehäuseteil (13,27) und zwischen dem Elastomer (8) und dem zweiten Gehäuseteil (27) angeordnet ist und von der Dichteinrichtung (28) das zweite Gehäuseteil (27) gegen das erste Gehäuseteil (13) und das zweite Gehäuseteil (27) gegen das Elastomer (8) abdichtet wird.

## Claims

1. Power semiconductor module comprising a substrate (19) and power semiconductor components (22) which are arranged on the substrate (19) and are connected to the substrate (19), wherein the power semiconductor module (14) has a first housing part (13) having a cutout (15) and a DC voltage load connection apparatus (1) forming a structural unit, wherein the DC voltage load connection apparatus (1) has a first and a second electrically conductive DC voltage load connection element (2, 5), which are each electrically conductively connected to at least one power semiconductor component (22), wherein the first DC voltage load connection element (2) has a first external connection section (3) arranged outside the first housing part (13), and the second DC voltage load connection element (5) has a second external connection section (6) arranged outside the first housing part (13), wherein the first DC voltage load connection element (2) has a first internal connection section (4) arranged inside the first housing part (13), and the second DC voltage load connection element (5) has a second internal connection section (7) arranged inside the first housing part (13), wherein the first DC voltage load connection element (2) has a first leadthrough section (10) arranged in the cutout (15), and the second DC voltage load connection element (5) has a second leadthrough section (11) arranged in the cutout (15), wherein a gap (12) is formed between the first and the second leadthrough sections (10, 11), wherein the first and second leadthrough sections (10, 11) are sheathed by an electrically nonconductive elastomer (8), and the elastomer (8) fills the gap (12), wherein the elastomer (8) is cohesively connected to the first and second leadthrough sections (10, 11) and is non-cohesively connected to the first housing part (13), wherein the elastomer (8) seals off the first and second leadthrough sections (10, 11) with respect to the first housing part (13).

2. Power semiconductor module according to Claim 1, **characterized in that** the elastomer (8) is in the form of silicone.

3. Power semiconductor module according to one of the preceding claims, **characterized in that** the elastomer (8) forms a sealing lip (9), wherein the sealing lip (9) presses against the first housing part (13).

4. Power semiconductor module according to one of the preceding claims, **characterized in that** the power semiconductor module (14) has a second housing part (27), wherein the second housing part (27) is connected to the first housing part (13), wherein a sealing device (28) is arranged between the first and second housing parts (13, 27) and between the elastomer (8) and the second housing part (27) and seals off the second housing part (27) with respect to the first housing part (13) and the second housing part (27) with respect to the elastomer (8).

5. Power semiconductor module according to Claim 4, **characterized in that** the sealing device (28) is cohesively connected to the second housing part (27).

6. Power semiconductor module according to one of the preceding claims, **characterized in that** the gap (12) extends beyond the length (l1) of the first and second leadthrough sections (10, 11) arranged in the cutout (15), and the elastomer (8) fills the gap (12) over the entire length (l2) of the gap (12), and the first and second DC voltage load connection elements (2, 5) are sheathed by the elastomer (8) over the entire length (l2) of the gap (12).

7. Power semiconductor module according to one of the preceding claims, **characterized in that** the elastomer (8) is connected in a form-fitting manner to the first and second DC voltage load connection elements (2, 5) in all three spatial directions (X, Y, Z), for this purpose, the first DC voltage load connection element (2) has a first section (30), which is bent back with respect to the first leadthrough section (10), and the second DC voltage load connection element (5) has a second section (31), which is bent back with respect to the second leadthrough section (11), wherein the bent-back first and second sections (30, 31) are sheathed by the elastomer (8).

8. Method for producing a power semiconductor module comprising a substrate (19) and power semiconductor components (22), which are arranged on the substrate (19) and are connected to the substrate (19), wherein the power semiconductor module (14) has a first housing part (13) having a cutout (15), said method comprising the following method steps:
• arranging a DC voltage load connection apparatus (1) forming a structural unit in the cutout (15), wherein the DC voltage load connection apparatus (1) has a first and a second electrically conductive DC voltage load connection element (2, 5), wherein the first DC voltage load connection element (2) has a first external connection section (3) and the second DC voltage load connection element (5) has a second external connection section (6), wherein the first DC voltage load connection element (2) has a first internal connection section (4), and the second DC voltage load connection element (5) has a second internal connection section (7), wherein the first DC voltage load connection element (2) has a first leadthrough section (10) arranged between the first internal connection section (4) and the first external connection section (3), and the second DC voltage load connection element (5) has a second leadthrough section (11) arranged between the second internal connection section (7) and the second external connection section (6), wherein a gap (12) is formed between the first and second leadthrough sections (10, 11), wherein the first and second leadthrough sections (10, 11) are sheathed by an electrically nonconductive elastomer (8), and the elastomer (8) fills the gap (12), wherein the elastomer (8) is cohesively connected to the first and second leadthrough sections (10, 11),
wherein the DC voltage load connection apparatus (1) is arranged in the cutout (15) in such a way that, once the DC voltage load connection apparatus (1) has been arranged, the first and second external connection sections (3, 6) are arranged outside the first housing part (13), and the first and second internal connection sections (4, 7) are arranged inside the first housing part (13), and the first and second leadthrough sections (10, 11) are arranged in the cutout (15), wherein the first and second leadthrough sections (10, 11) are sealed off with respect to the first housing part (13) by the elastomer (8),
• electrically conductively connecting the first and second DC voltage load connection elements (2, 5) in each case to at least one power semiconductor component (22).

9. Method according to Claim 8 comprising the further method step:
• connecting a second housing part (27) to the first housing part (13), wherein a sealing device (28) is arranged on the second housing part (27) and is cohesively connected to the second housing part (27), wherein the second housing part (27) is connected to the first housing part (13) and the sealing device (28) is arranged in such a way that, once the second housing part (27) has been connected to the first housing part (13), the sealing device (28) is arranged between the first and second housing parts (13, 27) and between the elastomer (8) and the second housing part (27), and the second housing part (27) is sealed off with respect to the first housing part (13) and the second housing part (27) is sealed off with respect to the elastomer (8) by the sealing device (28).

10. Method according to Claim 8 comprising the following further method steps:
• arranging a sealing device (28) on a second housing part (27) or on the first housing part (13),
• connecting the second housing part (27) to the first housing part (13), wherein the second housing part (27) is connected to the first housing part (13) and the sealing device (28) is arranged in such a way that, once a second housing part (27) has been connected to the first housing part (13), the sealing device (28) is arranged between the first and second housing parts (13, 27) and between the elastomer (8) and the second housing part (27), and the second housing part (27) is sealed off with respect to the first housing part (13) and the second housing part (27) is sealed off with respect to the elastomer (8) by the sealing device (28).

## Revendications

1. Module semi-conducteur de puissance comportant un substrat (9) et des éléments semi-conducteurs de puissance (22) disposés sur le substrat (19) et reliés au substrat (19), dans lequel le module semi-conducteur de puissance (14) comporte une première partie de boîtier (13) comportant un évidement (15) et un dispositif de connexion de charge à tension continue (1) formant une unité architecturale, dans lequel le dispositif de connexion de charge à tension continue (1) comporte des premier et second éléments de connexion de charge à tension continue (2, 5) électriquement conducteurs qui sont respectivement reliés de manière électriquement conductrice à au moins un composant semi-conducteur de puissance (22), dans lequel le premier élément de connexion de charge à tension continue (2) comporte une première section de connexion externe (3) disposée à l'extérieur de la première partie de boîtier (13) et le second élément de connexion de charge à tension continue (5) comporte une seconde section de connexion externe (6) disposée à l'extérieur de la première partie de boîtier (13), dans lequel le premier élément de connexion de charge à tension continue (2) comporte une première section de connexion interne (4) disposée à l'intérieur de la première partie de boîtier (13) et le second élément de connexion de charge à tension continue (5) comporte une seconde section de connexion interne (7) disposée à l'intérieur de la première partie de boîtier (13), dans lequel le premier élément de connexion de charge à tension continue (2) comporte une première section d'exécution (10) disposée dans l'évidement (15) et le second élément de connexion de charge à tension continue (5) comporte une seconde section d'exécution (11) disposée dans l'évidement (15), dans lequel un interstice (12) est formé entre les première et seconde sections d'exécution (10, 11), dans lequel les première et seconde sections d'exécution (10, 11) sont enveloppées d'un élastomère (8) non électriquement conducteur et l'élastomère (8) remplit l'interstice (12), dans lequel l'élastomère (8) est relié par complémentarité de matériau aux première et seconde sections d'exécution (10, 11) et n'est pas relié par complémentarité de matériau à la première partie de boîtier (13), dans lequel l'élastomère (8) étanchéifie les première et seconde sections d'exécution (10, 11) par rapport à la première partie de boîtier (13).

2. Module semi-conducteur de puissance selon la revendication 1, **caractérisé en ce que** l'élastomère (8) est réalisé sous forme de silicone.

3. Module semi-conducteur de puissance selon l'une quelconque des revendications précédentes, **caractérisé en ce que** l'élastomère (8) forme une lèvre d'étanchéité (9), dans lequel la lèvre d'étanchéité (9) appuie contre la première partie de boîtier (13).

4. Module semi-conducteur de puissance selon l'une quelconque des revendications précédentes, **caractérisé en ce que** le module semi-conducteur de puissance (14) comporte une seconde partie de boîtier (27), dans lequel la seconde partie de boîtier (27) est reliée à la première partie de boîtier (13), dans lequel un dispositif d'étanchéité (28) est disposé entre les première et seconde parties de boîtier (13, 27) et entre l'élastomère (8) et la seconde partie de boîtier (27), lequel dispositif d'étanchéité étanchéifie la seconde partie de boîtier (27) par rapport à la première partie de boîtier (13) et la seconde partie de boîtier (27) par rapport à l'élastomère (8).

5. Module semi-conducteur de puissance selon la revendication 4, **caractérisé en ce que** le dispositif d'étanchéité (28) est relié par complémentarité de matériau à la seconde partie de boîtier (27).

6. Module semi-conducteur de puissance selon l'une quelconque des revendications précédentes, **caractérisé en ce que** l'interstice (12) s'étend sur la longueur (11) des première et seconde sections d'exécution (10, 11) disposées dans l'évidement (15) et **en ce que** l'élastomère (8) remplit l'interstice (12) sur la totalité de la longueur (12) dudit interstice (12) et **en ce que** les premier et second éléments de connexion de charge à tension continue (2, 5) sont enveloppés sur la totalité de la longueur (12) de l'interstice (12) par l'élastomère (8).

7. Module semi-conducteur de puissance selon l'une quelconque des revendications précédentes, **caractérisé en ce que** l'élastomère (8) est relié par complémentarité de forme dans la totalité des trois directions spatiales (X, Y, Z) aux premier et second éléments de connexion de charge à tension continue (2, 5), dans lequel le premier élément de connexion de charge à tension continue (2) comporte à cet effet une première section (30) déroulée par rapport à la première section d'exécution (10) et le second élément de connexion de charge à tension continue (5) comporte une seconde section (31) déroulée par rapport à la seconde section d'exécution (11), dans lequel les première et seconde sections (30, 31) déroulées sont enveloppées par l'élastomère (8).

8. Procédé de fabrication d'un module semi-conducteur de puissance comportant un substrat (19) et des composants semi-conducteurs de puissance (22) disposés sur le substrat (19) et reliés au substrat (19), dans lequel le module semi-conducteur de puissance (14) comporte une première partie de boîtier (13) comportant un évidement (15), comprenant les étapes de procédé consistant à :
- disposer un dispositif de connexion de charge à tension continue (1) formant une unité architecturale, dans l'évidement (15), dans lequel le dispositif de connexion de charge à tension continue (1) comporte des premier et second éléments de connexion de charge à tension continue (2, 5) électriquement conducteurs, dans lequel le premier élément de connexion de charge à tension continue (2) comporte une première section de connexion externe (3) et le second élément de connexion de charge à tension continue (5) comporte une seconde section de connexion externe (6), dans lequel le premier élément de connexion de charge à tension continue (2) comporte une première section de connexion interne (4) et le second élément de connexion de charge à tension continue (5) comporte une seconde section de connexion interne (7), dans lequel le premier élément de connexion de charge à tension continue (2) comporte une première section d'exécution (10) disposée entre la première section de connexion interne (4) et la première section de connexion externe (3) et le second élément de connexion de charge à tension continue (5) comporte une seconde section d'exécution (11) disposée entre la seconde section de connexion interne (7) et la seconde section de connexion externe (6), dans lequel un interstice (12) est formé entre les première et seconde sections d'exécution (10, 11), dans lequel les première et seconde sections d'exécution (10, 11) sur enveloppées d'un élastomère (8) non électriquement conducteur et l'élastomère (8) remplit l'interstice (12), dans lequel l'élastomère (8) est relié par complémentarité de matériau aux première et seconde sections d'exécution (10, 11), dans lequel le dispositif de connexion de charge à tension continue (1) est disposé dans l'évidement (15) de manière à ce qu'après la mise en place du dispositif de connexion de charge à tension continue (1), les première et seconde sections de connexion externes (3, 6) soient disposées à l'extérieur de la première partie de boîtier (13) et à ce que les première et seconde sections de connexion internes (4, 7) soient disposées à l'intérieur de la première partie de boîtier (13), et à ce que les première et seconde sections d'exécution (10, 11) soient disposées dans l'évidement (15), dans lequel les première et seconde sections d'exécution (10, 11) sont étanchéifiées par rapport à la première partie de boîtier (13) par l'élastomère (8) non électriquement conducteur,
- relier respectivement de manière électriquement conductrice les premier et second éléments de connexion de charge à tension continue (2, 5) à au moins un composant semi-conducteur de puissance (22).

9. Procédé selon la revendication 8, comprenant les étapes supplémentaires de procédé consistant à :
- relier une seconde partie de boîtier (27) à la première partie de boîtier (13), dans lequel un dispositif d'étanchéité (18) est disposé sur la seconde partie de boîtier (27) et est relié par complémentarité de matériau à la seconde partie de boîtier (27), dans lequel la seconde partie de boîtier (27) est reliée à la première partie de boîtier (13) et le dispositif d'étanchéité (28) est agencé de manière à ce qu'après la liaison de la seconde partie de boîtier (27) à la première partie de boîtier (13), le dispositif d'étanchéité (28) soit disposée entre les première et seconde parties de boîtier (13, 27) et entre l'élastomère (8) et la seconde partie de boîtier (27) et à ce que le dispositif d'étanchéité (28) étanchéifie la seconde partie de boîtier (27) par rapport à la première partie de boîtier (13) et la seconde partie de boîtier (27) par rapport à l'élastomère (8).

10. Procédé selon la revendication 8, comprenant les étapes de procédé supplémentaires consistant à :
- disposer un dispositif d'étanchéité (28) sur une seconde partie de boîtier (27) ou sur la première partie de boîtier (13),
- relier la seconde partie de boîtier (27) à la première partie de boîtier (13), dans lequel la seconde partie de boîtier (27) est reliée à la première partie de boîtier (13) et le dispositif d'étanchéité (28) est agencé de manière à ce qu'après la liaison de la seconde partie de boîtier (27) à la première partie de boîtier (13), le dispositif d'étanchéité (28) soit disposé entre les première et seconde parties de boîtier (13, 27) et entre l'élastomère (8) et la seconde partie de boîtier (27) et à ce que le dispositif d'étanchéité (28) étanchéifie la seconde partie de boîtier (27) par rapport à la première partie de boîtier (13) et la seconde partie de boîtier (27) par rapport à l'élastomère (8).
